Europäisches Patentamt

European Patent Office

Office européen des brevets

(11) Veröffentlichungsnummer: **0 528 281 A2**

# (12) EUROPÄISCHE PATENTANMELDUNG

(21) Anmeldenummer: **92113424.3**

(22) Anmeldetag: **06.08.92**

(51) Int. Cl.5: **H01L 21/334**, H01L 29/92

(30) Priorität: **14.08.91 DE 4126917**

(43) Veröffentlichungstag der Anmeldung:
**24.02.93 Patentblatt 93/08**

(84) Benannte Vertragsstaaten:
**AT BE CH DE ES FR GB IT LI NL SE**

(71) Anmelder: **SIEMENS AKTIENGESELLSCHAFT**
**Wittelsbacherplatz 2**
**W-8000 München 2(DE)**

(72) Erfinder: **Lehmann, Volker, Dr.**
**Geyersperger Strasse 53**
**W-8000 München 21(DE)**
Erfinder: **Boy, Michael**
**Starkenfeldstrasse 8**
**W-8600 Bamberg(DE)**
Erfinder: **Hönlein, Wolfgang, Dr.**
**Ludwig-Thoma-Strasse 60**
**W-8025 Unterhaching(DE)**

(54) **Schaltungsstuktur mit mindestens einem Kondensator und Verfahren zu dessen Herstellung.**

(57) Ein Kondensator ist aus einem dotierten, einkristallinen Siliziumsubstrat (1), das durch eine elektrochemische Ätzung in einem fluoridhaltigen, sauren Elektrolyten, indem das Substrat als Anode verschaltet ist, mit einer Vielzahl von Lochöffnungen (3) versehen ist, einer dielektrischen Schicht (4) und einer leitfähigen Schicht (5) als Gegenelektrode aufgebaut.

FIG 1

EP 0 528 281 A2

In vielen technischen Gebieten, z. B. in der Mikroelektronik und für Audio- und Videoanwendungen, sind Kondensatoren mit großer spezifischer Kapazität von Interesse. Die spezifische Kapazität $C_S$ ist definiert als Kapazität C eines Kondensators multipliziert mit der Nennspannung U dividiert durch sein Volumen V:

$$C_S = (C \cdot U)/V.$$

Als Kondensatoren mit großer spezifischer Kapazität sind Elektrolytkondensatoren auf Aluminium- oder Tantalbasis bekannt. Diese Elektrolytkondensatoren sind die einzigen bekannten Kondensatoren, die eine spezifische Kapazität im Bereich von 10 - 100 $\mu$FV/mm$^3$ erreichen.

Elektrolytkondensatoren weisen jedoch einige Nachteile auf: Bei Verpolung werden die Elektrolytkondensatoren zerstört. Des weiteren werden sie bei Temperaturen über etwa 150 °C zerstört. Die maximale Betriebstemperatur liegt bei etwa 125 °C nach Datenblatt. Bedingt durch den Serienwiderstand ESR der Anordnung, ist ein Elektrolytkondensator nur bis zu einer Grenzfrequenz $f_G$ von etwa 100 kHz einsetzbar. Die Verwendung eines Elektrolyten bringt Alterungsprobleme des Kondensators mit sich. Elektrolytkondensatoren sind auf einem Siliziumchip nicht integrierbar. Im übrigen weisen Elektrolytkondensatoren eine begrenzte mechanische Festigkeit auf.

Aus Halbleiterspeicherschaltungen sind Trenchkondensatoren bekannt. Ein Trenchkondensator wird dabei gebildet aus einer leitfähigen Schicht, die an der Oberfläche eines in einem Siliziumsubstrat erzeugten Grabens angeordnet ist, einer darauf angeordneten dielektrischen Schicht und einer Gegenelektrode. Da die Gräben im Silizium durch Plasmaätzen erzeugt werden, ist das Verhältnis Grabentiefe zu Grabenöffnung auf Wert um zehn begrenzt. Daher ist die Oberflächenvergrößerung durch Grabenätzung auf Werte um 15 begrenzt.

Aus DE 23 28 090 C2 ist ein Verfahren zur Herstellung eines Halbleiterkondensators bekannt, bei dem die Oberfläche eines Substrats aus einkristallinem Silizium durch eine kristallorientierungsabhängige Ätzung mit Rinnen versehen wird. Die Ätzung erfolgt mit einer 50%igen Kaliumhydroxid/Wassermischung bei 85 °C. Es werden Rinnen mit einer Tiefe von 500 $\mu$m und mit einer Breite von 5 $\mu$m, die in Abständen von 10 $\mu$m angeordnet sind, gebildet. Auf diese Weise kann die Oberfläche um bis zu dem Hundertfachen vergrößert werden. Die maximal erreichbare spezifische Kapazität ist damit bei einem auf diese Weise hergestellten Kondensator auf 2,3 $\mu$FV/ mm$^3$ begrenzt.

Der Erfindung liegt das Problem zugrunde, eine Schaltungsstruktur mit mindestens einem Kondensator anzugeben, dessen spezifische Kapazität derjenigen von Elektrolytkondensatoren entspricht, der aber die Nachteile der Elektrolytkondensatoren vermeidet. Der Erfindung liegt des weiteren das Problem zugrunde, ein Verfahren zur Herstellung einer solchen Schaltungsstruktur anzugeben.

Das Problem wird erfindungsgemäß gelöst mit einer Schaltungsstruktur nach Anspruch 1 sowie einem Verfahren zu deren Herstellung nach Anspruch 13.

Durch die elektrochemische Ätzung wird die Oberfläche des Substrats auf charakteristische Weise strukturiert. Es bilden sich an der Oberfläche des Substrats mehr oder weniger regelmäßig angeordnete Lochstrukturen. Mit diesen Lochstrukturen werden Aspektverhältnisse bis in den Bereich 1:1000 erzielt.

In der erfindungsgemäßen Schaltungsstruktur wird die wirksame Fläche des Kondensators durch die Vielzahl von Lochöffnungen in der ersten Oberfläche um ein Vielfaches gegenüber dem Platzbedarf des Kondensators auf dem Substrat vergrößert. Dadurch sind in der erfindungsgemäßen Schaltungsstruktur mit Elektrolytkondensatoren vergleichbare spezifische Kapazitäten erreichbar. In dem erfindungsgemäßen Kondensator werden spezifische Kapazitäten bis maximal 100 $\mu$FV/mm$^3$, typisch aber im Bereich von etwa 10 $\mu$FV/mm$^3$ erzielt.

Bei Verpolung zeigt der durch elektrochemische Ätzung hergestellte Kondensator in der erfindungsgemäßen Schaltungsstruktur zwar eine kleinere Kapazität, er weist jedoch die gleiche oder eine etwas höhere Durchbruchsspannung auf und wird daher bei Verpolung nicht zerstört. In Schaltungsanwendungen, in denen bei Verpolung gleiche Kapazitäten auftreten sollen, liegt es im Rahmen der Erfindung, in der Schaltungsstruktur zwei baugleiche Kondensatoren vorzusehen, die gegenpolig parallel verschaltet sind. Um bei Verpolung gleiche Kapazität zu erzielen, liegt es weiterhin im Rahmen der Erfindung, das Substrat nach der elektrochemischen Ätzung höher zu dotieren.

Der Kondensator in der erfindungsgemäßen Schaltungsstruktur ist bei Verwendung von Wolfram-Kontakten bis etwa 600 °C temperaturunempfindlich. Die relative Änderung der Kapazität mit der Temperatur liegt unter 1 % pro 100 °C. Da der Kondensator ein Feststoffkondensator ist, sind parasitäre Widerstände in der erfindungsgemäßen Schaltungsstruktur minimiert. Im Vergleich zu Elektrolyten weisen feste Leiter geringere Widerstände auf. Der Kondensator ist bis zu einer Grenzfrequenz $f_G$ im Bereich 1 MHz einsetzbar.

Es liegt im Rahmen der Erfindung, als dielektrische Schicht Siliziumdioxid, Siliziumnitrid oder Titandioxid oder Kombinationen aus diesen Schichten zu verwenden. Siliziumdioxid ist eines der am besten bekannten Dielektrika und läßt sich daher sehr gut beherrschen. Mit einem Dielektrikum aus Titandioxid werden wegen der höheren Dielektrizitätskonstanten größere Kapazitäten erzielt. Bei Verwendung eines Mehrschichtdielektrikums mit einer Schichtenfolge $SiO_2$, $Si_3N_4$, $SiO_2$ werden besonders geringe Defektdichten erreicht.

Der Kondensator in der erfindungsgemäßen Schaltungsstruktur enthält weder Schwermetalle noch Elektrolyten. Daher ist er gut umweltverträglich.

Die erfindungsgemäße Schaltungsstruktur wird vorzugsweise mit Hilfe einer elektrochemischen Ätzung hergestellt. Dadurch sind Lochöffnungen erzielbar, bei denen das Verhältnis aus Tiefe zu Durchmesser erheblich größer als 10, insbesondere zwischen 25 und 1000, liegt. Damit werden Oberflächenvergrößerungen von 35 bis 1400 erreicht.

Ein Verfahren zur Erzeugung von Lochöffnungen oder Gräben in n-dotierten Silizium durch eine elektrochemische Ätzung ist zwar aus der europäischen Patentanmeldung EP 0 296 348 Al bekannt. Es wird jedoch zur Herstellung von Trenchkondensatoren, von tiefen vertikalen Dotierungen bei geringer horizontaler Dotiertiefe, wie sie z. B. für steuerbare Kondensatoren (Varicaps) großer Kapazität benötigt werden, zur Herstellung von tiefen, schmalen Gräben zur elektrischen Isolation benachbarter Bereiche in einem Siliziumsubstrat, zur Kontaktierung tief liegender Schichten oder zur Herstellung spannungsgesteuerter Transistoren beschrieben. Da dieses Verfahren für mikroelektronische Anwendungen, bei denen Defektdichten des Dielektrikums im Bereich $1/cm^2$ liegen, optimiert ist, kann es auf die Herstellung von Kondensatoren mit großen spezifischen Kapazitäten nicht ohne weiteres übertragen werden, da Defektdichten dieser Größenordnung hier nicht hinnehmbar sind.

Das erfindungsgemäße Herstellverfahren geht von einem Substrat aus n-dotiertem Silizium aus. Es werden handelsübliche Substrate verwendet. Dadurch ist die Herstellung des Kondensators preiswert. Auf dem Substrat können gleichzeitig eine Vielzahl von Kondensatoren hergestellt werden, die im letzten Verfahrensschritt getrennt werden. Der Kondensator ist mechanisch stabil. Es ist möglich den Kondensator in einer Schaltungsstruktur mit weiteren Schaltungselementen zu integrieren. Ausgehend von einer handelsüblichen Siliziumscheibe wird eine Bauhöhe von 0,5 mm erzielt, so daß der Kondensator für SMD- (Surface Mounted Device)-Anwendungen ideal einsetzbar ist.

Zur Optimierung des Herstellverfahrens fließt das gesamte Know-How der Siliziummikroelektronik ein.

Nach der Herstellung der Lochöffnungen wird an der Oberfläche des Substrats eine dielektrische Schicht erzeugt. Da die dielektrische Schicht die gesamte Oberfläche, auch im Bereich der Lochöffnungen konform bedecken sollte, eignen sich als dielektrische Schichten solche, die thermisch oder durch Gasphasenabscheidung herstellbar sind. Es hat sich herausgestellt, daß auf diese Weise hergestellte dielektrische Schichten sehr geringe Defektdichten aufweisen, was für das Funktionieren des Kondensators, insbesondere bei großen Aspektverhältnissen, entscheidend ist. Die dielektrische Schicht wird z. B. durch thermische Oxidation aus $SiO_2$ gebildet. Dieses Verfahren ist nur mit geringem Aufwand verbunden.

Durch Verwendung eines Mehrschichtdielektrikums, z. B. eine Schichtenfolge Siliziumoxid-Siliziumnitrid-Siliziumoxid (sogenanntes ONO), läßt sich die Defektdichte noch weiter bis zu Werten besser 1/400 $cm^2$ verkleinern, die notwendig sind, um fertigungsgerechte Ausbeuten zu erreichen.

Es liegt im Rahmen der Erfindung, die dielektrische Schicht aus $SiO_2$ durch eine anodische Oxidation, insbesondere in einem essigsäurehaltigen Elektrolyten, zu bilden. Anodisches Siliziumdioxid hat gegenüber thermischem Siliziumdioxid den Vorteil, daß es bei Raumtemperatur erzeugt wird. Dadurch werden mechanische Spannungen vermieden. Darüberhinaus ist die Oxidbildung bei der anodischen Oxidation ein selbstheilender Prozeß, da an einer Dünnstelle im Oxid durch Feldstärkeerhöhung verstärkte Oxidation auftritt. Dadurch wird die Dünnstelle verstärkt; der Defekt heilt aus.

Bei Herstellung der dielektrischen Schicht durch Gasphasenabscheidung von Titandioxid wird im fertigen Kondensator eine größere Kapazität bei gleicher Schichtdicke der dielektrischen Schicht erzielt.

Bei der elektrochemischen Ätzung wird diejenige Oberfläche des Substrats, in der durch die Ätzung Lochöffnungen erzeugt werden sollen, mit einem Elektrolyten in Kontakt gebracht. Es wird ein fluoridhaltiger, saurer Elektrolyt verwendet. Gegebenenfalls kann der Elektrolyt darüberhinaus Netzmittel oder andere Säuren enthalten. Der Materialabtrag der elektrochemischen Ätzung wird vergrößert, wenn die dem Elektrolyten abgewandte Oberfläche des Substrats beleuchtet wird.

Bei der elektrochemischen Ätzung wird das Substrat als Anode geschaltet. Dadurch bewegen sich Minoritätsladungsträger in dem n-dotierten Silizium zur mit dem Elektrolyten in Kontakt stehenden Oberfläche. An dieser Oberfläche bildet sich eine Raumladungszone aus. Da die Feldstärke im Bereich von Vertiefungen in der Oberfläche größer ist als außerhalb davon, bewegen sich die Minoritätsladungsträger bevorzugt zu diesen Punkten. Dadurch kommt es zu einer Strukturierung der Oberfläche. Je tiefer eine anfänglich kleine Unebenheit durch die Ätzung wird, desto mehr Minoritätsträger bewegen sich dort hin und desto stärker ist der Ätzangriff an dieser Stelle.

Um eine gleichmäßige Verteilung der Lochöffnungen im Substrat zu erzielen, ist es vorteilhaft, die Oberfläche vor der elektrochemischen Ätzung mit einer Oberflächentopologie zu versehen. Diese Oberflächentopologie enthält Unebenheiten, die als Keim für den Ätzangriff bei der nachfolgenden elektrochemischen Ätzung wirken. Es liegt im Rahmen der Erfindung, eine solche Oberflächentopologie mit Hilfe konventioneller Photolithographie herzustellen. Dabei wird nach Erzeugung einer Photolackmaske durch anisotrope Ätzung die Oberfläche des Substrats mit der Oberflächentopologie versehen. Nach Ablösung der Photolackmaske erfolgt die elektrochemische Ätzung.

Eine weitere Möglichkeit zur Bildung einer Oberflächentopologie besteht darin, die Oberfläche des Substrats mit einem der Oberflächentopologie entsprechenden Beleuchtungsmuster zu beleuchten. Das Potential an dem Substrat wird dabei so eingestellt, daß ohne Beleuchtung noch keine elektrochemische Ätzung eintritt. Die Beleuchtungsstärke wird so gewählt, daß bei Beleuchtung der Oberfläche des Substrats durch Bildung von Elektron-Lochpaaren ein Strom fließt, der für die elektrochemische Ätzung ausreichend ist und der gleichzeitig den maximalen Wert für elektrochemische Ätzung nicht überschreitet. Auf diese Weise wird das Substrat nur an den beleuchteten Stellen geätzt. Dadurch entstehen Unebenheiten, die beim nachfolgenden elektrochemischen Ätzen als Keime wirken. Bei diesem lichtinduzierten elektrochemischen Ätzen braucht keine Photolackmaske erzeugt zu werden. Eine Belichtung durch eine zwischen Substrat und Lichtquelle angeordnete Maske ist ausreichend. Es ist ebenfalls möglich, die Belichtung mit Hilfe eines Beugungsmusters oder eines Holograms durchzuführen.

Zur Herstellung einer Vielzahl von Kondensatoren wird ein scheibenförmiges Substrat ganzflächig mit Lochöffnungen versehen. Nach ganzflächigem Aufbringen der dielektrischen Schicht, der leitfähigen Schicht und des Kontaktes werden einzelne Kondensatoren mit Hilfe konventioneller Photolithographie definiert. Durch Ätzen bis auf die dielektrische Schicht werden die einzelnen Kondensatoren strukturiert. Anschließend werden die Kondensatoren durch Sägen und Brechen, wie aus der Chip-Herstellung bekannt ist, vereinzelt.

Im folgenden wird die Erfindung anhand von Ausführungsbeispielen und der Figuren näher erläutert.

Fig. 1 stellt einen Schnitt durch einen erfindungsgemäßen Kondensator dar.

Fig. 2 stellt die Kennlinie eines Elektrolyt-n-dotiertes-Silizium- Kontaktes dar.

Fig. 3 stellt einen Schnitt durch einen erfindungsgemäßen Kondensator dar, der von der Oberfläche her kontaktiert ist.

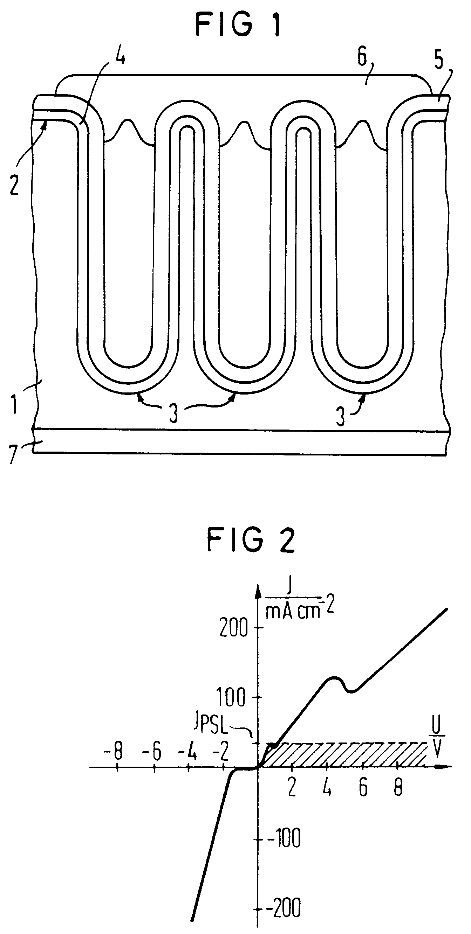

Ein Substrat 1 aus n-dotiertem, einkristallinem Silizium, das einen spez. Widerstand von 5 Ohm x cm aufweist, ist an einer ersten Oberfläche 2 mit einer Vielzahl von Lochöffnungen 3 versehen. Die Lochöffnungen 3 weisen einen Durchmesser von z. B. 2 $\mu$m und eine Tiefe von z. B. 200 $\mu$m auf (s. Fig. 1, in der Darstellung wurde in Richtung der Lochtiefe ein anderer Maßstab als in Richtung des Lochdurchmessers verwendet). Die erste Oberfläche ist konform mit einer dielektrischen Schicht 4 bedeckt. Die dielektrische Schicht 4 besteht z. B. aus $SiO_2$ und weist eine Dicke von z. B. 60 nm auf. Auf der dielektrischen Schicht 4 ist eine leitfähige Schicht 5 angeordnet. Die leitfähige Schicht 5 besteht z. B. aus n-dotiertem Polysilizium. Die leitfähige Schicht 5 bedeckt die dielektrische Schicht 4 vollständig.

Die leitfähige Schicht 5 wird durch einen ersten Kontakt 6 kontaktiert. Der erste Kontakt 6 besteht z. B. aus Aluminium. Aufgrund der Oberflächenspannung des Aluminiums besteht der erste Kontakt 6 aus einer durchgehenden Schicht, die im Bereich der Lochöffnungen 3 nur den oberen Teil der leitfähigen Schicht 5 kontaktiert. Die aufgrund der Struktur im Bereich der Lochöffnungen 3 bestehenden Spalten zwischen benachbarten Oberflächen der leitfähigen Schicht 5 werden durch den ersten Kontakt nicht ausgefüllt. Für die Funktionsweise des Kondensators ist dieses auch nicht erforderlich, da die leitfähige Schicht 5 als Gegenelektrode wirkt. Auf der der ersten Oberfläche 2 abgewandten Oberfläche des Substrats ist ein zweiter Kontakt 7 aus z. B. Aluminium aufgebracht. Soll der Kondensator hochtemperaturfest sein, so werden der erste Kontakt 6 und der zweite Kontakt 7 z. B. aus Wolfram aufgebracht.

Wird im Betrieb der erste Kontakt 6 mit einem Pluspol und der zweite Kontakt 7 mit einem Minuspol verbunden, weist der Kondensator maximale Kapazität auf. Bei entgegengesetzter Polung ist die Kapazität minimal. Durch Dotierung des Substrates z. B. mit As oder P mit einer Dotierstoffkonzentration im Bereich $10^{19}$ -$10^{21}$ cm$^{-3}$ nach der elektrochemischen Ätzung hat die Kapazität unabhängig von der Polung immer den Maximalwert.

Fig. 2 zeigt die Kennlinie eines Kontaktes zwischen einem fluoridhaltigem sauren Elektrolyten und n-dotiertem Silizium.

In dem schraffierten Bereich der Kennlinie findet elektrochemisches Ätzen statt. Oberhalb des schraffierten Bereiches wird eine elektropolierende Oberflächenschicht gebildet. Beim Elektropolieren können sich an der Oberfläche keine Strukturen mehr ausbilden. Für das elektrochemische Ätzen ist es daher wichtig, die Stromdichte so einzustellen, daß der Kontakt in dem schraffierten Bereich der Kennlinie ist. Dieses erfolgt über die Einstellung der Stromdichte.

Zur Herstellung des in Fig. 1 dargestellten Kondensators wird das Siliziumsubstrat mit einer Oberflächentopologie versehen. Dies erfolgt z. B. konventionell mit Hilfe von Photolithographie oder durch Beleuchtung der Substratoberfläche, während sich diese im Kontakt mit dem Elektrolyten befindet und die Stromdichte im unteren Bereich des schraffierten Bereichs der Kennlinie in Fig. 2 gehalten wird.

Anschließend erfolgt die Bildung der Lochöffnungen 3 mit Hilfe einer elektrochemischen Ätzung. Als Elektrolyt wird dabei z. B. 6%ige Flußsäure (HF) verwendet. Das n-dotierte Substrat wird als Anode mit einem Potential von 3 Volt beaufschlagt. Das Substrat wird von der Rückseite her beleuchtet. Es wird eine Stromdichte von 10 mA/cm$^2$eingestellt. Nach ungefähr 150 Minuten Ätzzeit weisen die Lochöffnungen einen Durchmesser von 2 $\mu$m bei einer Tiefe von 200 $\mu$m auf.

Anschließend wird das Substrat in einer alkalischen Lösung, die z. B. 50 % Ethylendiamin enthält, 5 Minuten unter positiven Potential von z. B. 10 Volt gespült. Dabei wird poröses Silizium entfernt, das sich bei dem elektrochemischen Ätzen an der Oberfläche des Substrats bildet.

Nach grünalichem Spülen mit Wasser wird auf dem Substrat 1 die dielektrische Schicht 4 durch anodische Oxidation gebildet.

Dazu wird das Substrat 1 in einem Elektrolyten, der z. B. 2%ige Essigsäure enthält, bei einer Stromdichte von z. B. 10 $\mu$A/cm$^2$ oxidiert. Die Dicke der dabei gebildeten dielektrischen Schicht 4 aus SiO$_2$ wird über die Dauer der Oxidation gesteuert. Eine Dicke von 60 nm ergibt sich z. B. in 16 Stunden.

Eine weitere Möglichkeit zur Herstellung der dielektrischen Schicht 4 besteht in einer thermischen Oxidation der Oberfläche der Lochöffnungen 3. Dabei muß jedoch mit größeren mechanischen Spannungen in dem Substrat 1 gerechnet werden, da das thermische SiO$_2$ nicht bei Raumtemperatur erzeugt werden kann. Die leitfähige Schicht 5 wird in einem Standard CVD- Prozeß aus n-dotiertem Polysilizium auf der dielektrischen Schicht 4 abgeschieden.

Zur besseren Kontaktierung werden der erste Kontakt 6 und der zweite Kontakt 7 durch Bedampfen mit z. B. Aluminium gebildet.

Mit Hilfe konventioneller Photolithographie werden an der Scheibenoberfläche einzelne Kondensatoren definiert. Der erste Kontakt aus Aluminium und die leitfähige Schicht 5 aus Polysilizium werden dabei bis auf die dielektrische Schicht 4 geätzt. Durch Sägen und Brechen werden anschließend die Kondensatoren vereinzelt.

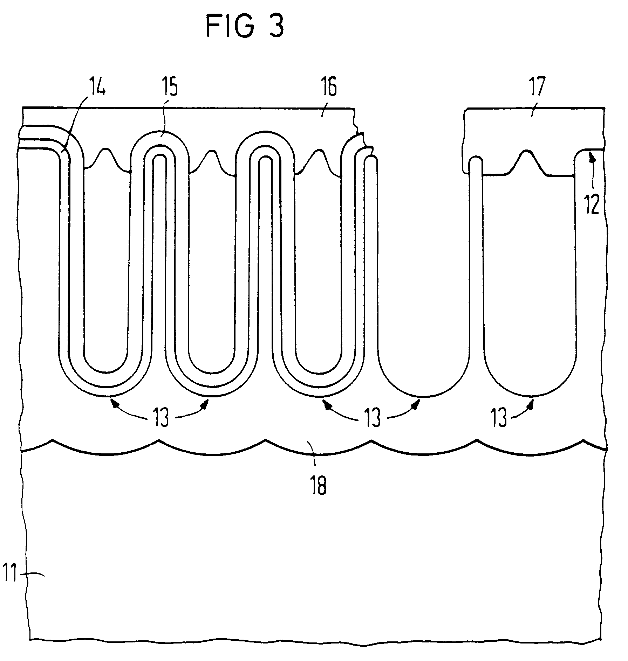

Ein Substrat 11 aus n-dotiertem, einkristallinem Silizium, das einen spezifischen Widerstand von 5 Ohm x cm aufweist, ist an einer ersten Oberfläche 12 mit einer Vielzahl von Lochöffnungen 13 versehen. Die Lochöffnungen 13 weisen einen Durchmesser von z. B. 1 $\mu$m und eine Tiefe von z. B. 400 $\mu$m auf (s. Fig. 3, nicht maßstäblich). Die Lochöffnungen 13 sind in dem Substrat 11 durch eine elektrochemische Ätzung in einem fluoridhaltigen, sauren Elektrolyten, in dem das Substrat 11 als Anode verschaltet ist, hergestellt worden, analog dem anhand von Fig. 1 und Fig. 2 beschriebenen.

Die erste Oberfläche 12 ist konform mit einer dielektrischen Schicht 14 bedeckt. Die dielektrische Schicht 14 ist z. B. durch kombiniertes Aufbringen von SiO$_2$, Si$_3$N$_4$ und nochmals SiO$_2$ hergestellt und weist eine Dicke von 60 nm auf. Auf der dielektrischen Schicht 14 ist eine leitfähige Schicht 15 angeordnet. Die leitfähige Schicht 15 besteht z. B. aus n-dotiertem Polysilizium.

Die dielektrische Schicht 14 und die leitfähige Schicht 15 sind seitlich begrenzt. Dabei ragt die dielektrische Schicht 14 über die leitfähige Schicht 15 hinaus. Die leitfähige Schicht 15 wird durch einen ersten Kontakt 16 kontaktiert. Der erste Kontakt 16 besteht z. B. aus Aluminium. Aufgrund der Oberflächenspannung des Aluminiums besteht der erste Kontakt 16 aus einer durchgehenden Schicht, die im Bereich der Lochöffnungen 13 nur den oberen Teil der leitfähigen Schicht 15 kontaktiert. Der erste Kontakt 16 wird so strukturiert, daß er ausschließlich auf der seitlich begrenzten leitfähigen Schicht 15 angeordnet ist.

In dem Substrat 11 ist an der ersten Oberfläche 12 ein Bereich 18 erhöhter Dotierung angeordnet. Die Dotierung im Bereich 18 wird nach der elektrochemischen Ätzung mit As oder P auf eine Dotierstoffkonzentration im Bereich 10$^{19}$ bis 10$^{21}$ cm$^{-3}$ eingestellt. Der Bereich 18 erhöhter Dotierung bewirkt, daß die Kapazität des Kondensators unabhängig von der Polung immer den Maximalwert aufweist.

Seitlich von der dielektrischen Schicht 14 und der leitfähigen Schicht 15 ist auf der freiliegenden ersten Oberfläche 12 ein zweiter Kontakt 17 angeordnet. Der zweite Kontakt 17 kontaktiert direkt den Bereich 18 erhöhter Dotierung. Durch die Anordnung des zweiten Kontaktes 17 an der ersten Oberfläche 12 wird der Serienwiderstand ESR der Anordnung reduziert, so daß der Kondensator bis zu Grenzfrequenzen im Bereich 1 MHz einsetzbar ist. Außerdem ist der anhand von Fig. 3 dargestellte Kondensator wegen der Anordnung sowohl des ersten Kontaktes 16 als auch des zweiten Kontaktes 17 an der ersten Oberfläche 12 zur Integration in einen Siliziumchip geeignet.

**Patentansprüche**

1. Schaltungsstruktur mit mindestens einem Kondensator,
   - bei der ein Substrat (1) aus dotiertem, einkristallinem Silizium mit einer ersten Oberfläche (2) vorgesehen ist,
   - bei der mindestens in einem Teil der ersten Oberfläche (2) durch eine elektrochemische Ätzung in einem fluoridhaltigen sauren Elektrolyten, in dem das Substrat (1) als Anode verschaltet ist, mit Lochöffnungen (3) versehen ist, deren Tiefe größer als ihr Durchmesser ist,
   - bei der auf der ersten Oberfläche (2) eine dielektrische Schicht (4) angeordnet ist, die die erste Oberfläche (2) mindestens im Bereich der Lochöffnungen (3) konform bedeckt und deren Schichtdicke geringer als ein halber Durchmesser der Lochöffnungen (3) ist,
   - bei der auf der dielektrischen Schicht (4) eine leitfähige Schicht (5) angeordnet ist,
   - bei der das Substrat (1) und die leitfähige Schicht (5) jeweils mit einem Kontakt (6, 7) versehen sind.

2. Schaltungsstruktur nach Anspruch 1, bei der das Verhältnis aus Tiefe der Lochöffnungen (3) zu Durchmesser der Lochöffnungen (3) mindestens 100 beträgt.

3. Schaltungsstruktur nach Anspruch 1 oder 2, bei der die dielektrische Schicht (4) mindestens eines der Materialien anodisches $SiO_2$, thermisches $SiO_2$, $Si_3N_4$ oder $TiO_2$ enthält.

4. Schaltungsstruktur nach Anspruch 3, bei der die dielektrische Schicht (4) mindestens aus zwei Schichten unterschiedlichen Materials zusammengesetzt ist.

5. Schaltungsstruktur nach einem der Ansprüche 1 bis 4, bei der die leitfähige Schicht (5) die Oberfläche der dielektrischen Schicht (4) konform bedeckt.

6. Schaltungsstruktur nach Anspruch 5, bei der die leitfähige Schicht (5) dotiertes Polysilizium enthält.

7. Schaltungsstruktur nach einem der Ansprüche 1 bis 6, bei der im Substrat (11) an der ersten Oberfläche (12) mindestens im Bereich der Lochöffnungen (13) ein Bereich erhöhter Dotierung angeordnet ist.

8. Schaltungsstruktur nach einem der Ansprüche 1 bis 7, bei der die dielektrische Schicht (14) und die leitfähige Schicht (15) seitlich begrenzt sind und bei der der Kontakt (17) zu dem Substrat (11) an der ersten Oberfläche (12) angeordnet ist.

9. Schaltungsstruktur nach einem der Ansprüche 1 bis 8, bei der der auf der leitfähigen Schicht (5) angeordnete Kontakt (6) eine zu einer zweiten, der ersten Oberfläche (2) abgewandten Oberfläche des Substrats (1) parallele Oberfläche aufweist.

10. Schaltungsstruktur nach einem der Ansprüche 1 bis 9, bei der die Kontakte (6, 7) Aluminium enthalten.

11. Schaltungsstruktur nach einem der Ansprüche 1 bis 10, bei der ein zweiter, zum ersten baugleicher Kondensator vorgesehen ist und bei der der zweite Kondensator gegenpolig parallel zum ersten geschaltet ist.

12. Schaltungsstruktur nach einem der Ansprüche 1 bis 11, bei der in dem Substrat (1) weitere Schaltelemente integiert enthalten sind.

13. Verfahren zur Herstellung einer Schaltungsstruktur mit mindestens einem Kondensator,
   - bei dem in ein Substrat (1) aus einkristallinem, n-dotiertem Silizium eine Vielzahl von Lochöffnungen (3) durch eine elektrochemische Ätzung in einem fluoridhaltigen, sauren Elektrolyten, bei der das Substrat (1) als Anode einer Elektrolysierzelle geschaltet ist, geätzt wird,
   - bei der die Oberfläche der Lochöffnungen (3) mit einer dielektrischen Schicht (4) versehen wird, die konform abgeschieden wird in einer geringeren Dicke, als es der Hälfte eines Durchmessers der Lochöffnungen (3) entspricht,
   - bei der mittels Gasphasenabscheidung auf der dielektrischen Schicht (4) eine leitfähige Schicht (5) gebildet wird.

14. Verfahren nach Anspruch 13, bei dem die Lochöffnungen (3) mit Durchmessern im Bereich 0,1 $\mu$m bis 10 $\mu$m und mit Tiefen im Bereich 10 $\mu$m bis 500 $\mu$m erzeugt werden.

15. Verfahren nach Anspruch 13 oder 14, bei dem die dem Elektrolyten abgewandte Oberfläche des Substrats (1) beleuchtet wird.

16. Verfahren nach einem der Ansprüche 13 bis 15, bei dem die dem Elektrolyten zugewandte Oberfläche des Substrats (1) vor der elektrochemischen Ätzung mit einer Oberflächentopologie versehen wird.

17. Verfahren nach Anspruch 16, bei dem die Oberflächentopologie mit Hilfe von Photolithographie hergestellt wird.

18. Verfahren nach Anspruch 16, bei dem die Oberflächentopologie durch lichtinduzierte elektrochemische Ätzung mit einem der Oberflächentopologie entsprechenden Beleuchtungsmuster erzeugt wird.

19. Verfahren nach einem der Ansprüche 13 bis 18, bei dem das Substrat (1) nach der elektrochemischen Ätzung in einer alkalischen Lösung gespült wird, wobei das Substrat (1) als Anode geschaltet ist.

20. Verfahren nach einem der Ansprüche 13 bis 19, bei dem die dielektrische Schicht (4) durch thermische Oxidation gebildet wird.

21. Verfahren nach einem der Ansprüche 13 bis 19, bei dem die dielektrische Schicht (4) durch anodische Oxidation gebildet wird.

22. Verfahren nach Anspruch 21, bei dem die anodische Oxidation in einem essigsäurehaltigen Elektrolyten durchgeführt wird.

23. Verfahren nach einem der Ansprüche 13 bis 19, bei dem die dielektrische Schicht (4) durch Gasphasenabscheidung von $TiO_2$ gebildet wird.

24. Verfahren nach einem der Ansprüche 13 bis 23, bei dem die leitfähige Schicht (5) durch Gasphasenabscheidung von dotiertem Polysilizium gebildet wird.

25. Verfahren nach einem der Ansprüche 13 bis 24, bei dem das Substrat (1) nach der elektrochemischen Ätzung mit einem der Dotierstoffe As oder P auf mindestens $10^{19}$ cm$^{-3}$ dotiert wird.

26. Verfahren nach einem der Ansprüche 13 bis 25, bei dem die leitfähige Schicht (5) durch Ätzen bis auf die dielektrische Schicht (4) strukturiert wird.

27. Verfahren nach Anspruch 26, bei dem die dielektrische Schicht (4) durch Ätzen bis auf das Substrat (1) strukturiert wird und bei dem auf der freigelegten Oberfläche des Substrats (1) ein Kontakt (7) zum Substrat (1) gebildet wird.

28. Verfahren nach einem der Ansprüche 13 bis 27, bei dem auf der Oberfläche der leitfähigen Schicht (5) und auf einer Oberfläche des Substrats (1) durch Bedampfen mit Metall Kontakte (6, 7) hergestellt werden.

29. Verfahren nach einem der Ansprüche 13 bis 28, bei dem die dielektrische Schicht (4) durch kombinierte Abscheidung von $SiO_2$ und $Si_3N_4$ (ONO) gebildet wird.

## FIG 1

## FIG 2

## FIG 3